# EUROPEAN PATENT APPLICATION

(11) **EP 4 704 349 A1**
(43) Date of publication of application: **04.03.2026**
(21) Application number: 24197842.8
(22) Date of filing: 02.09.2024
(51) Int. Cl.: H04B 1/48, H04B 1/04, H04B 1/18

(54) **APPARATUS FOR TRANSMITTING AND RECEIVING SIGNALS**

(71) Applicant: NXP B.V., 5656 AG Eindhoven (NL)
(72) Inventor: ENAM, Syed Khursheed, 5656 AG Eindhoven (NL); CHEN, Yi-Wen, 5656 AG Eindhoven (NL); AFSHAR, Sherwin Ali, 5656 AG Eindhoven (NL); ROUFOOGARAN, Rozi, 5656 AG Eindhoven (NL)
(74) Representative: Krott, Michel

(57) **Abstract**

An apparatus comprising: an antenna pin coupled to a pair of antenna inductors; a first set of differential input-output pins coupled to a first pair of inductors. The first pair of inductors are configured to magnetically couple with the pair of antenna inductors for transmitting signalling. The apparatus further comprises a function switch, comprising: a second set of differential input-output pins, coupled to a second pair of inductors. The function switch comprises a first switch between the second pair of inductors. The second pair of inductors are configured to magnetically couple with the pair of antenna inductors for receiving signalling. The function switch comprises a third set of differential input-output pins coupled to a third pair of inductors. The function switch comprises a second switch between the third pair of inductors. The third pair of inductors are configured to magnetically couple with the pair of antenna inductors for receiving signalling.

## Description

### Field

The present disclosure relates to an apparatus and, in particular, to an apparatus configured to receive a signal for transmission from an input and provide a received signal to an output and which is capable of transmitting and receiving signalling or signals using the same pin. The disclosure also relates to an apparatus comprising a transmit/receive switch.

### Summary

According to a first aspect of the present disclosure there is provide an apparatus comprising:
an antenna pin for coupling to an antenna, the antenna pin coupled to at least a first antenna inductor in series with a second antenna inductor, wherein the second antenna inductor is further coupled to a first reference pin configured to provide a first reference voltage;
a first set of differential input-output pins comprising a first input-output pin and second input-output pin, wherein the first input-output pin is coupled to a first inductor in series with a second inductor, and wherein the second inductor is further coupled to the second input-output pin, wherein the apparatus further comprises a first supply terminal coupled between the first inductor and the second inductor to receive a first supply voltage, wherein
   the first inductor is configured to magnetically couple with the first antenna inductor and the second inductor is configured to magnetically couple with the second antenna inductor for transmission of signalling received at the first set of differential input-output pins from the antenna when it is coupled to the antenna pin; and
a function switch, comprising:
   a second set of differential input-output pins, comprising a third input-output pin and fourth input-output pin, wherein the third input-output pin is coupled to a third inductor in series with a fourth inductor, and wherein the fourth inductor is further coupled to the fourth input-output pin, and wherein the function switch comprises a first switch between the third inductor and the fourth inductor, wherein
      the third inductor is configured to magnetically couple with the first antenna inductor and the fourth inductor is configured to magnetically couple with the second antenna inductor for provision of signalling received from the antenna pin to the second set of differential input-output pins;
   a third set of differential input-output pins, comprising a fifth input-output pin and sixth input-output pin, wherein the fifth input-output pin is coupled to a fifth inductor in series with a sixth inductor, and wherein the sixth inductor is further coupled to the sixth input-output pin, and wherein the function switch comprises a second switch between the fifth inductor and the sixth inductor, wherein
      the fifth inductor is configured to magnetically couple with the first antenna inductor and the sixth inductor is configured to magnetically couple with the second antenna inductor for provision of signalling received from the antenna pin to the third set of differential input-output pins.

In one or more embodiments, the apparatus includes a receiver amplifier arrangement. In one or more embodiments, the second set of differential input-output pins and the third set of differential input-output pins are configured to be connected to a receiver amplifier arrangement that is configured to receive the signalling received from the antenna via the antenna pin. The receiver amplifier arrangement may comprise a first part formed of at least a pair of PMOS transistors and a second part formed of at least a pair of NMOS transistors.

In one or more embodiments,
the second set of differential input-output pins are connected to the first part of the receiver amplifier arrangement; and, in one or more embodiments
the third set of differential input-output pins are connected to the second part of the receiver amplifier arrangement.

In one or more embodiments,
the first switch is connected to a second supply terminal which is configured to receive a second supply voltage, such that when the first switch is closed, the third inductor and the fourth inductor receive the second supply voltage, and when the first switch is open, the third inductor is not connected to the fourth inductor; and, in one or more embodiments
the second switch is connected to a second reference terminal configured to receive a second reference voltage, such that when the second switch is closed, the fifth inductor and the sixth inductor receive the second reference voltage, and when the second switch is open, the fifth inductor is not connected to the sixth inductor.

In one or more embodiments, the apparatus is configured to operate in a transmit mode and a receive mode wherein:
when the apparatus is in the transmit mode, the first switch and the second switch may be configured to be open, and the apparatus may be configured to receive signalling for transmission from the first set of differential input-output pins; and
when the apparatus is in the receive mode, the first switch and the second switch may be configured to be closed, and the apparatus may be configured to provide signalling received via the antenna pin to the second and third set of differential input-output pins, such that the second and third sets of differential input-output pins may be configured to provide the signalling as a differential signal to a receiver amplifier arrangement.

In one or more embodiments:
the first switch comprises a plurality of transistors configured to provide an open or non-conducting state and a closed or conducting state for individually controlling the impedance between the third inductor and the fourth inductor; and, in one or more embodiments
the second switch comprises a plurality of transistors configured to provide an open or non-conducting state and a closed or conducting state for individually controlling the impedance between the fifth inductor and the sixth inductor.

In one or more embodiments, wherein the apparatus is configured to operate in a fast-settle mode, wherein when the apparatus is in the fast-settle mode:
while the apparatus is providing signalling to the antenna:
one or more of the plurality of transistors of the first switch may be configured to be open;
one or more of the plurality of transistors of the first switch may be configured to be closed;
one or more of the plurality of transistors of the second switch may be configured to be open; and
one or more of the plurality of transistors of the second switch may be configured to be closed.

In one or more embodiments, wherein the apparatus is configured to operate in a fast-settle mode, while the apparatus is receiving signalling from the antenna:
all of the plurality of transistors in the first switch may be configured to be closed; and
all of the plurality of transistors in the second switch may be configured to be closed.

It will be appreciated that fast-settle is a notional name given to the mode in which the plurality of transistors have the states described herein and may, in some examples, provide for faster settling of signal disruptions that occur during switching of the function switch and the delivery of signalling to the receiver amplifier arrangement and receiving of signalling from the first set of differential input-output pins for transmission.

In one or more embodiments:
the first switch comprises:
a plurality of first PMOS transistors, connected in series in a chain such that a source terminal of one first PMOS transistor is connected to a drain terminal of an adjacent first PMOS transistor in the chain.

The source terminal of a first of the plurality of first PMOS transistors in the chain may be connected to the third inductor, and the drain terminal of a final first PMOS transistor in the chain may be connected to the fourth inductor.

A gate terminal of each of the first PMOS transistors may be connected to a first terminal of a respective resistor and wherein a second terminal of the respective resistor may be connected to a first switch control terminal.

In one or more embodiments:
the first switch comprises:
a plurality of second PMOS transistors, wherein
a source terminal of each second PMOS transistor may be connected to the second supply terminal, and a drain terminal of each second PMOS transistor may be connected to the source terminal of one first PMOS transistor and the drain terminal of its adjacent first PMOS transistor, such that one second PMOS transistor may be connected between each pair of first PMOS transistors.

In one or more example, a gate terminal of each second PMOS transistor may be connected to a first switch control terminal.

In one or more embodiments:
the second switch comprises:
a plurality of first NMOS transistors, connected in series in a chain such that a source terminal of one first NMOS transistor may be connected to a drain terminal of the adjacent first NMOS transistor.

The source terminal of a first of the plurality of first NMOS transistors in the chain may be connected to the fifth inductor, and the drain terminal of a final first NMOS transistor in the chain may be connected to the sixth inductor.

A gate terminal of each of the first NMOS transistors may be connected to a first terminal of a respective resistor and wherein a second terminal of the respective resistor may be connected to a second switch control terminal.

In one or more embodiments:
the second switch comprises:
a plurality of second NMOS transistors, wherein
a source terminal of each second NMOS transistor may be connected to the second reference terminal, and a drain terminal of each second NMOS transistor may be connected to the source terminal of one first NMOS transistor and the drain terminal of its adjacent first NMOS transistor, such that one second NMOS transistor may be connected between each pair of first NMOS transistors.

In one or more example, a gate terminal of each second NMOS transistor may be connected to a second switch control terminal.

In one or more embodiments:
when the apparatus is in the transmit mode, the first switch is open such that one or more signals which are provided to the first switch control terminals are configured to cause the plurality of first PMOS transistors and the plurality of second PMOS transistors to not conduct, and the second switch is open such that one or more signals which are provided to the second switch control terminals are configured to cause the plurality of first NMOS transistors and the plurality of second NMOS transistors to not conduct.

In one or more embodiments:
when the apparatus is in the receive mode, the first switch is closed such that one or more signals which are provided to the first switch control terminals are configured to cause the plurality of first PMOS transistors and the plurality of second PMOS transistors to conduct, and the second switch is closed such that one or more signals which are provided to the second switch control terminals are configured to cause the plurality of first NMOS transistors and the plurality of second NMOS transistors to conduct.

In one or more embodiments:
the plurality of first PMOS transistors may comprise three first PMOS transistors;
the plurality of second PMOS transistors may comprise two second PMOS transistors;
the plurality of first NMOS transistors may comprise three first NMOS transistors; and
the plurality of second NMOS transistors may comprise two second NMOS transistors.

In one or more embodiments:
the first switch comprises:
a plurality of first PMOS transistors, connected in series in a chain such that a source terminal of one first PMOS transistor may be connected to a drain terminal of the adjacent first PMOS transistor.

The source terminal of a first of the plurality of first PMOS transistors may be connected to the third inductor, and the drain terminal a final first PMOS transistor in the chain may be connected to the fourth inductor.

A gate terminal of the first of the plurality of first PMOS transistors and a gate terminal of the final first PMOS transistor in the chain may be connected to a first terminal of a respective resistor and wherein a second terminal of the respective resistor may be connected to a first switch control terminal, and a gate terminal of each other first PMOS transistor may be connected to a first switch blanking control terminal.

In one or more embodiments:
the first switch comprises:
a plurality of second PMOS transistors, wherein
a source terminal of each second PMOS transistor may be connected to the second supply terminal, and a drain terminal of each second PMOS transistor may be connected to the source terminal of one first PMOS transistor and the drain terminal of its adjacent first PMOS transistor, such that one second PMOS transistor may be connected between each pair of first PMOS transistors.

In one or more example, a gate terminal of each second PMOS transistor may be connected to a first switch blanking control terminal.

In one or more embodiments:
the second switch comprises:
a plurality of first NMOS transistors, connected in series in a chain such that a source terminal of one first NMOS transistor may be connected to a drain terminal of the adjacent series NMOS transistor.

The source terminal of a first of the plurality of first NMOS transistors may be connected to the fifth inductor, and the drain terminal of a final first NMOS transistor in the chain may be connected to the sixth inductor.

A gate terminal of the first of the plurality of first NMOS transistors and a gate terminal of the final first NMOS transistor in the chain may be connected to a first terminal of a respective resistor, and wherein a second terminal of the respective resistor may be connected to a second switch control terminal, and a gate terminal of each other first NMOS transistor may be connected to a second switch blanking control terminal.

In one or more embodiments:
the second switch comprises:
a plurality of second NMOS transistors, wherein
a source terminal of each second NMOS transistor may be connected to the second reference terminal, and a drain terminal of each second NMOS transistor may be connected to the source terminal of one first NMOS transistor and the drain terminal of its adjacent first NMOS transistor, such that one second NMOS transistor may be connected between each pair of first NMOS transistors.

In one or more example, a gate terminal of each second NMOS transistor may be connected to a second switch blanking control terminal.

In one or more embodiments:
when the apparatus is in the transmit mode:
the first switch may be open such that one or more signals which are provided to the first switch control terminals are configured to cause the first of the plurality of first PMOS transistors in the chain and the final first PMOS transistor in the chain to not conduct. One or more signals which are provided to the first switch blanking control terminals may be configured to cause each other first PMOS transistor of the plurality of first PMOS transistors and the plurality of second PMOS transistors to not conduct.

In one or more example, the second switch may be open such that one or more signals which are provided to the second switch control terminals may be configured to cause the first of the plurality of first NMOS transistors in the chain and the final first NMOS transistor in the chain to not conduct. One or more signals which are provided to the second switch blanking control terminals may be configured to cause each other first NMOS transistor of the plurality of first NMOS transistors and the plurality of second NMOS transistors to not conduct.

In one or more embodiments:
when the apparatus is in the receive mode:
the first switch may be open such that one or more signals which are provided to the first switch control terminals may be configured to cause the first of the plurality of first PMOS transistors and the final first PMOS transistor in the chain to conduct. One or more signals which are provided to the first switch blanking control terminals may be configured to cause each other first PMOS transistor of the plurality of first PMOS transistors and the plurality of second PMOS transistors to conduct.

The second switch may be open such that one or more signals which are provided to the second switch control terminals may be configured to cause the first of the plurality of first NMOS transistors in the chain and the final first NMOS transistor in the chain to conduct. One or more signals which are provided to the second switch blanking control terminals may be configured to cause each other first NMOS transistor of the plurality of first NMOS transistors and the plurality of parallel NMOS transistors to conduct.

In one or more embodiments:
when the apparatus is in the fast-settle mode:
one or more signals which are provided to the first switch blanking control terminals and the second switch blanking control terminals may be configured to cause one or more of the first PMOS transistors apart from the first and final first PMOS transistors in the chain, one or more of the first NMOS transistors apart from the first and final first NMOS transistors in the chain, the second PMOS transistors and the second NMOS transistors to not conduct, while the apparatus is providing signalling to the antenna. One or more signals which are provided to the first switch control terminals and the second switch control terminals may be configured to cause the first and final first PMOS transistors in the chain and the first and final first NMOS transistors in the chain to conduct, while the apparatus is providing signalling to the antenna.

In one or more embodiments:
when the apparatus is in the fast-settle mode:
one or more signals which are provided to the first switch blanking control terminals and the second switch blanking control terminals may be configured to cause one or more of the first PMOS transistors apart from the first and final first PMOS transistors in the chain, one or more of the first NMOS transistors apart from the first and final first NMOS transistors in the chain, the second PMOS transistors and the second NMOS transistors to conduct, while the apparatus is receiving signalling from the antenna. One or more signals which are provided to the first switch control terminals and the second switch control terminals may be configured to cause the first and last first PMOS transistors in the chain and the first and final first NMOS transistors in the chain to conduct, while the apparatus is receiving signalling from the antenna.

In one or more embodiments the receiver amplifier arrangement further comprises:
a first plurality of capacitors configured to, at least in part, cancel noise within the receiver amplifier arrangement;
a second plurality of capacitors configured to configured to, at least in part, cancel noise within the receiver amplifier arrangement;
one or more blanking supply voltage terminals configured to provide one or more blanking supply voltages.

During the fast-settle mode, while the apparatus is receiving signalling from the antenna, the receiver amplifier arrangement may be configured to provide the one or more blanking supply voltages to the first plurality of capacitors and the second plurality of capacitors.

In one or more embodiments:
a first PMOS transistor of the pair of PMOS transistors comprises:
a source terminal coupled to the third differential input-output pin;
a drain terminal coupled to a first output terminal;
a gate terminal coupled to a first terminal of a first-part first capacitor. A second terminal of the first-part first capacitor may be coupled to the fourth differential input-output pin.

In one or more embodiments:
a second PMOS transistor of the pair of PMOS transistors comprises:
a source terminal coupled to the fourth differential input-output pin;
a drain terminal coupled to a second output terminal;
a gate terminal coupled to a first terminal of a first-part second capacitor. A second terminal of the first-part second capacitor may be coupled to the third differential input-output pin.

In one or more embodiments:
the receiver amplifier arrangement further comprises a pair of output transistors, wherein:
a first output transistor of the pair of output transistors comprises:
a first channel terminal coupled to the first output terminal;
a second channel terminal coupled to the drain terminal of the first PMOS transistor of the pair of PMOS transistors and the drain terminal of the first NMOS transistor of the pair of NMOS transistors; and
a control terminal connected to a receiver amplifier supply terminal.

In one or more embodiments:
the receiver amplifier arrangement further comprises a pair of output transistors, wherein:
a second output transistor of the pair of output transistors comprises:
a first channel terminal coupled to the second output terminal;
a second channel terminal coupled to the drain terminal of the second PMOS transistor of the pair of PMOS transistors and the drain terminal of the second NMOS transistor of the pair of NMOS transistors; and
a control terminal connected to the receiver amplifier supply terminal.

In one or more embodiments, the pair of output transistors is a pair of output NMOS transistors.

In one or more embodiments:
the first part of the low noise amplifier circuit further comprises:
a first-part blanking supply voltage terminal configured to provide a first-part blanking supply voltage; and
a first-part blanking transistor with a drain terminal connected to the first-part blanking supply voltage terminal, a source terminal connected to the first terminal of the first-part first capacitor and the first terminal of the first-part second capacitor and a gate terminal connected to a first-part blanking control terminal.

In one or more embodiments:
a first NMOS transistor of the pair of NMOS transistors comprises:
a source terminal coupled to the fifth differential input-output pin;
a drain terminal coupled to the first output terminal;
a gate terminal coupled to a first terminal of a second-part first capacitor. A second terminal of the second-part first capacitor may be coupled to the sixth differential input-output pin.

In one or more embodiments:
a second PMOS transistor of the pair of PMOS transistors comprises:
a source terminal coupled to the sixth differential input-output pin;
a drain terminal coupled to the second output terminal;
a gate terminal coupled to a first terminal of a second-part second capacitor. A second terminal of the second-part first capacitor may be coupled to the fifth differential input-output pin.

In one or more embodiments:
the second part of the low noise amplifier circuit further comprises:
a second-part blanking supply voltage terminal configured to provide a second-part blanking supply voltage; and
a second-part blanking transistor with a drain terminal connected to the fourth supply voltage terminal, a source terminal connected to the first terminal of the second-part first capacitor and the first terminal of the second-part second capacitor and a gate terminal connected to a second-part blanking control terminal.

In one or more embodiments:
when the apparatus is in the transmit mode, one or more signals which are provided to the first-part blanking control terminal and the second-part blanking control terminal may be configured to cause the first-part blanking transistor and the second-part blanking transistor to not conduct.

In one or more embodiments:
when the apparatus is in the receive mode, one or more signals which are provided to the first-part blanking control terminal and the second-part blanking control terminal may be configured to cause the first-part blanking transistor and the second-part blanking transistor to conduct.

In one or more embodiments:
when the apparatus is in the fast-settle mode:
one or more signals which are provided to the first-part blanking control terminal and the second-part blanking control terminal may be configured to cause the first-part blanking transistor and the second-part blanking transistor to not conduct while the apparatus is providing signalling to the antenna, such that charge over the first-part first capacitor and the first-part second capacitor and the charge over the second-part first capacitor and the second-part second capacitor remains unchanged.

In one or more embodiments:
when the apparatus is in the fast-settle mode:
one or more signals which are provided to the first-part blanking control terminal and the second-part blanking control terminal may be configured to cause the first-part blanking transistor and the second-part blanking transistor to conduct while the receiver amplifier arrangement is receiving signalling from the antenna pin.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example apparatus according to an embodiment of this disclosure;
Figure 2 shows an example amplifier arrangement and an example function switch, according to an embodiment of the present disclosure;
Figure 3 shows an example first switch which is configured to operate in a transmit mode and a receive mode, according to an embodiment of the present disclosure;
Figure 4 shows an example second switch which is configured to operate in a transmit mode and a receive mode, according to an embodiment of the present disclosure;
Figure 5 shows an example first switch which is configured to operate in the transmit mode, the receive mode and a fast-settle mode, according to another embodiment of the present disclosure;
Figure 6 shows an example second switch which is configured to operate in the transmit mode, the receive mode and the fast-settle mode, according to another embodiment of the present disclosure; and
Figure 7 shows the second part of an example amplifier arrangement which is configured to operate in the transmit mode, the receive mode and the fast-settle mode, according to an embodiment of this disclosure.

### Detailed Description

An apparatus which is capable of transmitting and receiving signalling or signals using the same pin may be beneficial in a range of applications, for example in radar signalling, wherein a signal is transmitted and the reflection of the signal from an object is subsequently detected. In some examples, the apparatus may transmit and receive ultra-wide band (UWB) signals, but any other suitable signalling bandwidth may be used.

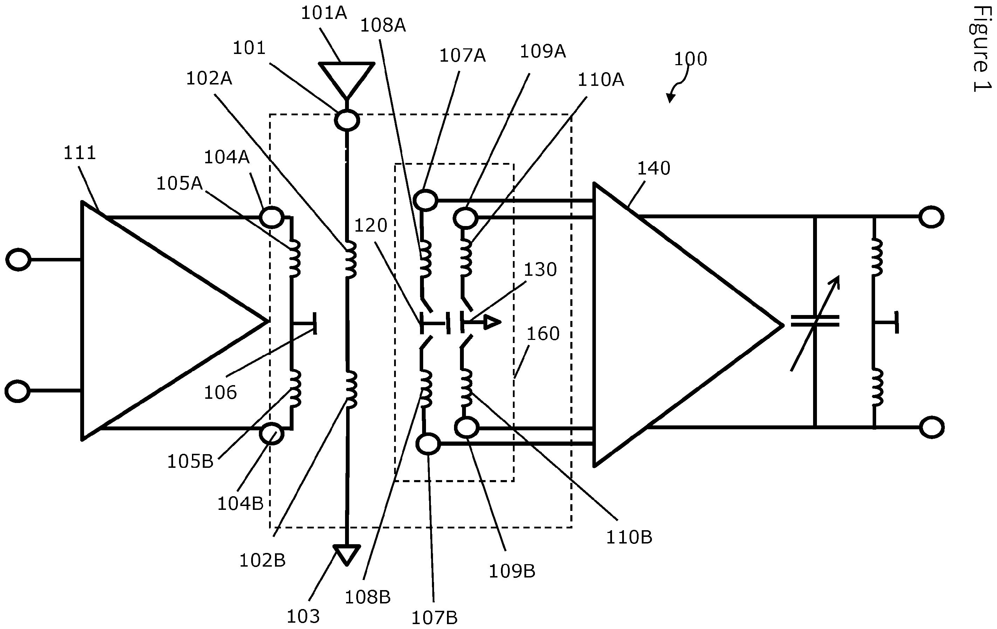

Figure 1 shows an example apparatus 100 according to an embodiment of this disclosure. The apparatus 100 comprises an antenna pin 101 coupled, in series, to a first antenna inductor 102A and a second antenna inductor 102B, wherein the second antenna inductor 102B is configured to be further coupled by its other terminal to a first reference terminal 103, configured to provide a first reference voltage. The first reference voltage may be ground, or any other suitable reference voltage. The apparatus also includes a first set of differential input-output pins, comprising a first input-output pin 104A and second input-output pin 104B, wherein the first input-output pin 104A is coupled to a first inductor 105A in series with a second inductor 105B, which is further coupled to the second input-output pin 104B. The apparatus further comprises a first supply terminal 106 between the inductors 105A, 105B to receive a first supply voltage. The first inductor 105A is configured to magnetically couple with the first antenna inductor 102A and the second inductor 105B is configured to magnetically couple with the second antenna inductor 102B. In this embodiment, the antenna pin 101 is connected to, or at least configured to connect to, an antenna 101A which is configured to transmit and receive signals.

The apparatus also includes a function switch 160 wherein the state of the switch is controlled based on whether the apparatus is operating in a transmit mode or a receive mode. The function switch 160 may be coupled to a second set of differential input-output pins, comprising a third input-output pin 107A and fourth input-output pin 107B. The third input-output pin 107A may be coupled to a first terminal of a third inductor 108A. A second terminal of the third inductor 108A is coupled to a first terminal of a fourth inductor 108B, such that the inductors are provided in series. A second terminal of the fourth inductor 108B is coupled to the fourth input-output pin 107B. A first switch 120 is located between the third and fourth inductors 108A, 108B, such that it is coupled between the second terminal of the third inductor 108A and the first terminal of the fourth inductor 108B. The third inductor 107A is configured to magnetically couple with the first antenna inductor 102A and the fourth inductor 107B is configured to magnetically couple with the second antenna inductor 102B. The function switch 160, in the present example, is coupled to a third set of differential input-output pins, comprising a fifth input-output pin 109A and sixth input-output pin 109b. The fifth input-output pin 109A may be coupled to a first terminal of a fifth inductor 110A. A second terminal of the fifth inductor 110A may be coupled to a first terminal of a sixth inductor 110B, such that the inductors are provided in series. A second terminal of the sixth inductor 110B is coupled to the sixth input-output pin 109b. A second switch 130 is located between the second terminal of the fifth inductor 110A and the first terminal of the sixth inductor 110B, such that they are coupled in series via said second switch 130. The fifth inductor 110A is configured to magnetically couple with the first antenna inductor 102A and the sixth inductor 110B is configured to magnetically couple with the second antenna inductor 102B. In this way, the second and third sets of differential input-output pins are configured to provide the signalling which is received from the antenna 101A as a differential signal to a receiver that is to be coupled to the second and third sets of differential input-output pins.

As mentioned previously, the antenna pin 101 is connected to an antenna 101A which is configured to transmit and receive signals. To facilitate this, in this embodiment, the first set of differential input-output pins 104A, 104B are connected to, or for connection to, a transmitter which is configured to transmit signals using the antenna 101A. In this embodiment, the second set of differential input-output pins 107A, 107B and the third set of differential input-output pins 109A, 109b are connected to, or for connection to, a receiver which is configured to receive signals from the antenna 101A. It will be appreciated that any other suitable circuit architecture which is configured to transmit and receive signals from a single pin antenna is possible.

In this embodiment, the transmitter includes a power amplifier circuit 111. The power amplifier circuit 111 may be configured to amplify signals for transmission by the antenna 101A. In some embodiments, the receiver includes a receiver amplifier arrangement. In this embodiment, the receiver amplifier arrangement comprises an LNA circuit 140. The LNA circuit 140 may be configured to amplify received signals from the antenna 101A, whilst maintaining their signal-to-noise ratio. The LNA circuit 140 may be a differential, complimentary (PMOS and NMOS) current-reuse common gate LNA. The LNA circuit 140 may be configured to provide both PMOS-based and NMOS-based amplification paths, which may reduce current consumption without a reduction in RF performance.

In some embodiments, the apparatus 100 may be configured to operate in a transmit mode and a receive mode. In these embodiments, the transmit mode and the receive mode are achieved by control of the first switch 120 and the second switch 130. In the transmit mode, the apparatus 100 is configured to transmit signals using the antenna pin 101. In the receive mode, the apparatus 100 is configured to receive signals from the antenna pin 101. The use of both the transmit mode and the receive mode allows the apparatus 100 to block transmission signals from the receiver wherever necessary, which can reduce interference, prevent damage to sensitive components and improve the power efficiency of the apparatus 100.

In the transmit mode, the first switch 120 and the second switch 130 are open, such that a high impedance is present between the third inductor 108A and the fourth inductor 108B, and a high impedance is present between the fifth inductor 110A and the sixth inductor 110B. This high impedance reduces the cross-coupling effect that the third inductor 108A, fourth inductor 108B, fifth inductor 110A and sixth inductor 110B have on the first inductor 105A and the second inductor 105B, when the transmitter is transmitting a signal. In this way, the power amplifier circuit 111 is able to more efficiently amplify signals for transmission, which can result in stronger signals being transmitted, or the same output power being achieved with less current consumption. Additionally, the high impedance provided by the first switch 120 and the second switch 130 also reduces the strength of the transmission signals which are unintentionally received by the receiver. Because less power is coupled to the LNA circuit 140, the potential damage for to the LNA circuit 140 and any other connected circuits as a result of excessive signal strength is reduced.

In the receive mode, the first switch 120 and the second switch 130 are closed, such that a low impedance is present between the third inductor 108A and the fourth inductor 108B, and a low impedance is present between the fifth inductor 110A and the sixth inductor 110B. In this way, the receiver is able to effectively receive signals from the antenna pin 101. The transmitter is inactive during the receive mode and is therefore unaffected by the action of the first switch 120 and the second switch 130.

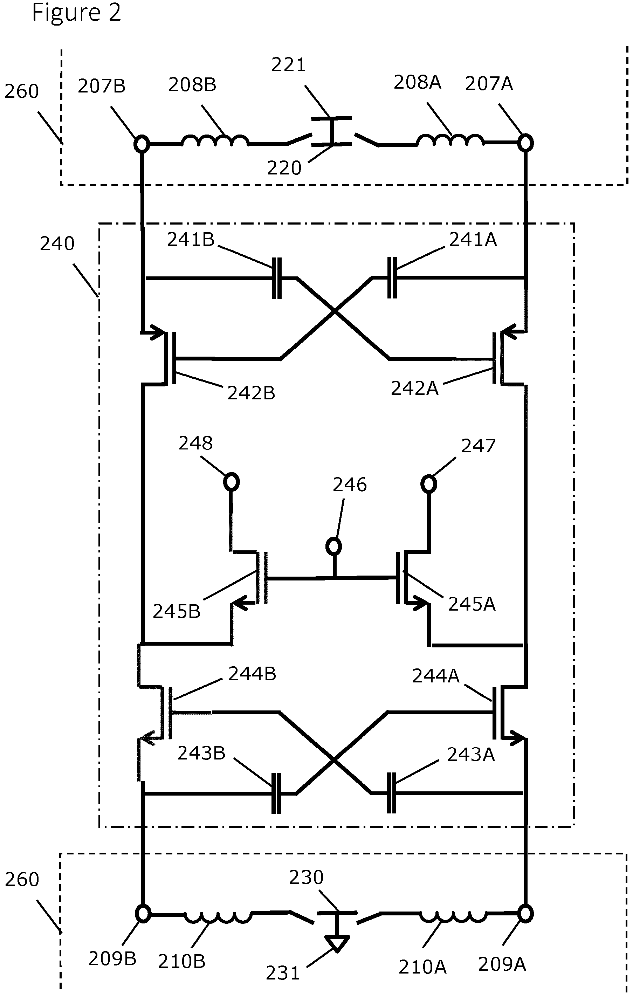

In some embodiments, the LNA circuit 140 includes a first part and a second part. One such example LNA circuit 140 will be discussed below, with reference to Figure 2. In these embodiments, the second set of differential input-output pins 107A, 107B are connected to the first part of the LNA circuit 140, and the third set of differential input-output pins 109A, 109b are connected to the second part of the LNA circuit 140, although the reverse is also possible.

Figure 2 shows an example LNA circuit 240 and a function switch 260, according to an embodiment of the present disclosure. In this example, the LNA circuit 240 includes a first part, which is shown in the top half of the figure, and the LNA circuit 240 includes a second part, which is shown in the bottom half of the figure. The first part includes a pair of PMOS transistors 242A, 242B and the second part includes a pair of NMOS transistors 244A, 244B.

In this embodiment, a first PMOS transistor 242A of the pair of PMOS transistors in the first part comprises: a source terminal coupled to the third differential input-output pin 207A, a drain terminal coupled to a first output terminal 247 and a gate terminal coupled to a first terminal of a first-part first capacitor 241B. A second terminal of the first-part first capacitor 241B is coupled to the fourth differential input-output pin 207B. The cross-coupled first-part first capacitor 241B and the first-part second capacitor 241A are configured to cancel noise within the LNA circuit 240. The connection provided by the first-part first transistor 241B, from the gate terminal of the first PMOS transistor 242A to the drain terminal of the second PMOS transistor 242B, ensures that any noise which is present on the first PMOS transistor 242A will also be present in the current path leading to the second differential output terminal 248. The presence of this noise within both differential output current paths has the effect that the noise is cancelled out when the LNA circuit 240 output is taken differentially. Similarly, the connection provided by the first-part second transistor 241A, from the gate terminal of the second PMOS transistor 242B to the drain terminal of the first PMOS transistor 242A, ensures that any noise which is present on the second PMOS transistor 242B will also be present in the current path leading to the first differential output terminal 247. The presence of this noise within both differential output current paths ensures that the effect of the noise is cancelled out when the LNA circuit 240 output is taken differentially.

Similarly, in this embodiment, a second PMOS transistor 242B of the pair of PMOS transistors comprises: a source terminal coupled to the fourth differential input-output pin 207B, a drain terminal coupled to a second output terminal 248 and a gate terminal coupled to a first terminal of a first-part second capacitor 241A. A second terminal of the first-part second capacitor 241A is coupled to the third differential input-output pin 207A.

The pair of NMOS transistors 244A, 244B in the second part are arranged in a similar fashion to the pair of PMOS transistors 242A, 242B in the first part. That is, a first NMOS transistor 244A of the pair of NMOS transistors in the second part comprises: a source terminal coupled to the fifth differential input-output pin 209A, a drain terminal coupled to a first output terminal 247 and a gate terminal coupled to a first terminal of a second-part first capacitor 243B. A second terminal of the second-part first capacitor 243B is coupled to the sixth differential input-output pin 209B.

A second NMOS transistor 244B of the pair of NMOS transistors comprises: a source terminal coupled to the sixth differential input-output pin 209B, a drain terminal coupled to a second output terminal 248 and a gate terminal coupled to a first terminal of a second-part second capacitor 243A. A second terminal of the second-part second capacitor 243A is coupled to the fifth differential input-output pin 209A. The second-part first capacitor 243B and the second-part second capacitor 243A are configured to cancel noise within the LNA circuit 240, by the same means as the first-part first capacitor 241B and the first-part second capacitor 241A, described above.

The example LNA circuit 240 also includes a pair of output NMOS transistors 245A, 245B. In other examples, the LNA circuit 240 may include a pair of output PMOS transistors instead of NMOS transistors. A source terminal of each of the output NMOS transistors 245A, 245B is connected to the drain terminal of one of the pair of PMOS transistors 242A, 242B and one of the pair of NMOS transistors 244A, 244B. That is, in this example, the source terminal of the first output NMOS transistor 245A is connected to the drain terminal of the first PMOS transistor 242A and the drain terminal of the first NMOS transistor 244A. Correspondingly, in this example the source terminal of the second output NMOS transistor 245B is connected to the drain terminal of the second PMOS transistor 242B and the drain terminal of the second NMOS transistor 244B. A gate terminal of each of the output NMOS transistors 245A, 245B is connected to an LNA supply terminal 246, which is configured to provide an LNA supply voltage. The drain terminal of each output NMOS transistor 245A, 245B is connected to one of a first output voltage terminal 247 or a second output voltage terminal 248. In this example, the first output terminal 247 is negative, and the second output terminal 248 is positive. However, in other examples, the first output terminal 247 may be positive and the second output terminal 248 may be negative, depending on the circuit topology.

Outside of the receiver amplifier arrangement or LNA circuit 240 as shown in the embodiment, Figure 2 also shows the function switch 260 (in two halves), including the first switch 220 and the second switch 230. In this embodiment, the first switch 220 is configured to connect the third inductor 208A and the fourth inductor 208B to either a second supply terminal 221 which is configured to receive a second supply voltage or the first switch is open. In this way, when the first switch 220 is closed (i.e., when the first switch 220 has a low impedance), the third inductor 208A and the fourth inductor 208B receive the second supply voltage. When the first switch 220 is open (i.e., when the first switch 220 has a high impedance), the third inductor 208A is not connected to the fourth inductor 208B. Similarly, the second switch 230 is configured to connect the fifth inductor 210A and the sixth inductor 210B to a second reference terminal 231 configured to receive a second reference voltage or the second switch 230 is open. When the second switch 230 is closed (i.e., the second switch 230 has a low impedance), the fifth inductor 210A and the sixth inductor 210B receive the second reference voltage. When the second switch 230 is open (i.e., when the second switch 230 has a high impedance), the fifth inductor 210A is not connected to the sixth inductor 210B.

The apparatus discussed in relation to Figures 1 and 2 is configured to operate in a transmit mode and a receive mode. When the apparatus 100 is in a transmit mode, the first switch 220 and the second switch 230 are configured to be open, and the transmitter is configured to transmit one or more signals from the antenna 101A. In this way, the transmitted signal(s) from the antenna 101A are not received by the LNA circuit 240, and as such the transmitted signal(s) are much less likely cause damage to the LNA circuit 240, or any other circuits connected thereto. When the apparatus 100 is in a receive mode, the first switch 220 and the second switch 230 are configured to be closed, and the receiver is configured to receive one or more signals from the antenna 101A. In this way, the receiver is able to perform its role effectively.

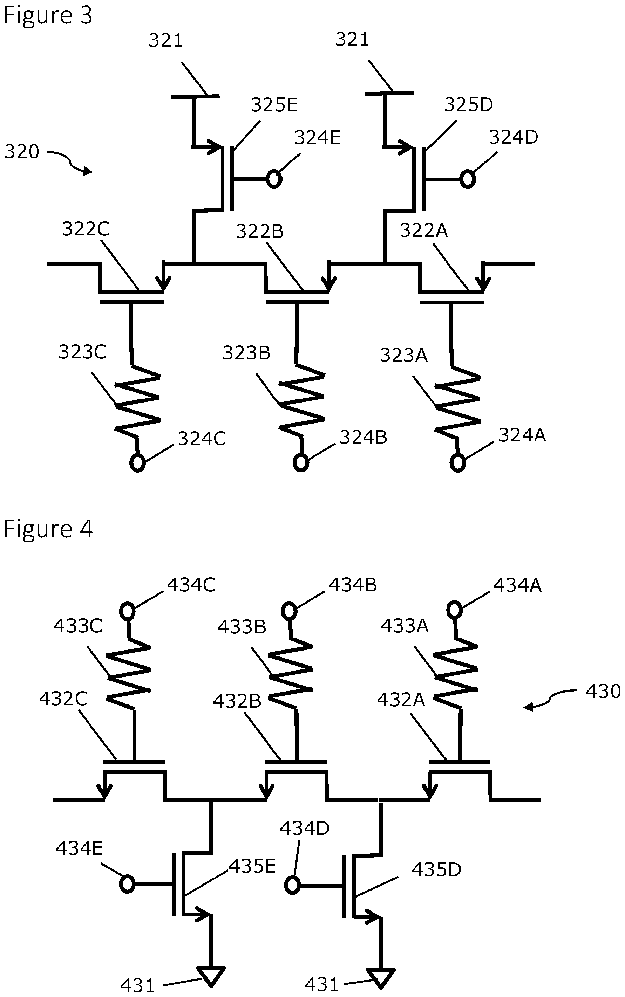

Figure 3 shows an example first switch 320 (example of first switch 120, 220), according to an embodiment of the present disclosure. The first switch 320 includes a plurality of transistors 322A, 322B, 322C, 322D, 322E. When the apparatus is in the transmission mode, all of the plurality of transistors 322A, 322B, 322C, 322D, 322E are configured to not conduct. When the apparatus is in the receive mode, all of the plurality of transistors 322A, 322B, 322C, 322D, 322E are configured to conduct. In this embodiment, the first switch 320 includes a plurality of first PMOS transistors 322A, 322B, 322C, connected in series in a chain such that a source terminal of one first PMOS transistor 322A, 322B, 322C is connected to a drain terminal of the adjacent first PMOS transistor 322A, 322B, 322C. In this example, the plurality of first PMOS transistors 322A, 322B, 322C includes three first PMOS transistors 322A, 322B, 322C, but other numbers of first PMOS transistors are possible. Therefore, in this example, the drain terminal of a first 322A of the first PMOS transistors in the chain is connected to the source of a second transistor 322B of the first PMOS transistors, and the drain of the second transistor 322B is connected to the source of a final transistor of the first PMOS transistors 322C in the chain. It will be appreciated that further first transistors could be coupled in this manner if present.

The source terminal of the first 322A of the plurality of first PMOS transistors in the chain is connected to the third inductor 108A, 208A. The drain terminal of a final 322C first PMOS transistor in the chain is connected to the fourth inductor 108B, 208B. It will be appreciated that in other examples, the third inductor may instead be connected to the drain terminal of the final first PMOS transistor in the chain, and the fourth inductor may instead be connected to the source terminal of the first of the plurality of first PMOS transistors in the chain. The gate terminal of each of the first PMOS transistors 322A, 322B, 322C is connected to a first terminal of a respective resistor 323A, 323B, 323C. A second terminal of each respective resistor 323A, 323B, 323C is connected to a first switch control terminal 324A, 324B, 324C.

The first switch 320 also includes a plurality of second PMOS transistors 325D, 325E, wherein a source terminal of each second PMOS transistor 325D, 325E is connected to the second supply terminal 321. The drain terminal of each second PMOS transistor 325D, 325E is connected to the source terminal of a respective one of the first PMOS transistor 323A, 323B, 323C and the drain terminal of its adjacent first PMOS transistor 323A, 323B, 323C. In this way, one second PMOS transistor 325D, 325E is connected between each pair of first PMOS transistors 323A, 323B, 323C. In this example, the plurality of second PMOS transistors 325D, 325E includes two second PMOS transistors 325D, 325E, but other numbers of second PMOS transistors are possible. In this example, the drain terminal of a first 325D of the second PMOS transistors is connected to the drain terminal of the first 322A of the first PMOS transistors and the source terminal of the second 322B of the first PMOS transistors. The drain terminal of a second transistor 325E of the second PMOS transistors is connected to the drain terminal of the second 322B of the first PMOS transistors and the source terminal of the final transistor 322C of the first PMOS transistors. The gate terminal of each second PMOS transistors 325D, 325E is connected to the first switch control terminal 324E, 324D.

The first switch control terminals 324A, 324B, 324C, 324D, 324E associated with each transistor of the first switch 320 may either be controlled independently, or together with each other first switch control terminal 324A, 324B, 324C, 324D, 324E. In this example, the first switch control terminals 324A, 324B, 324C, 324D, 324E are all controlled together.

When the apparatus is in the transmit mode, the first switch 320 is open such that one or more signals which are provided to the first switch control terminals 324A, 324B, 324C, 324D, 324E are configured to cause the plurality of first PMOS transistors 322A, 322B, 322C and the plurality of second PMOS transistors 325D, 325E to not conduct. When the apparatus is in the receive mode, the first switch 320 is closed such that one or more signals which are provided to the first switch control terminals 324A, 324B, 324C, 324D, 324E are configured to cause the plurality of first PMOS transistors 322A, 322B, 322C and the plurality of second PMOS transistors to conduct 325D, 325E. The one or more signals may be provided to the second switch control terminals 324A, 324B, 324C, 324D, 324E by a controller (not shown) or any other suitable means. The controller may be the same controller as a controller which is used to control the transmission and / or receipt of signals.

Figure 4 shows an example second switch 430 (example of second switch 130, 230), according to an embodiment of the present disclosure. The first switch 430 includes a plurality of transistors 432A, 432B, 432C, 432D, 432E. When the apparatus is in the transmission mode, all of the plurality of transistors 432A, 432B, 432C, 432D, 432E are configured to not conduct. When the apparatus is in the receive mode, all of the plurality of transistors 432A, 432B, 432C, 432D, 432E are configured to conduct. Similarly to the first switch, in this embodiment, the second switch 430 includes a plurality of first NMOS transistors 432A, 432B, 432C, connected in series in a chain such that a source terminal of one first NMOS transistor 432A, 432B, 432C is connected to a drain terminal of the adjacent first NMOS transistor 432A, 432B, 432C. In this example, the plurality of first NMOS transistors 432A, 432B, 432C includes three first NMOS transistors 432A, 432B, 432C, but other numbers of first NMOS transistors are possible. Therefore, in this example, the drain terminal of a first transistor 432A of the first NMOS transistors is connected to the source terminal of a second 432B of first NMOS transistors, and the drain terminal of the second 432B of the first NMOS transistors is connected to the source terminal of a final transistor 432C of the first NMOS transistors.

The source terminal of a first 432A of the plurality of first NMOS transistors in the chain is connected to the fifth inductor 110A, 210A. The drain terminal of a final transistor 432C of the first NMOS transistors in the chain is connected to the sixth inductor 110B, 210B. It will be appreciated that in other examples, the fifth inductor 110A may instead be connected to the drain terminal of the final one of the first NMOS transistor in the chain, and the sixth inductor may instead be connected to the source terminal of the first of the plurality of first NMOS transistors in the chain. A gate terminal of each of the first NMOS transistors 432A, 432B, 432C is connected to a first terminal of a respective resistor 433A, 433B, 433C. A second terminal of each respective resistor 433A, 433B, 433C is connected to a second switch control terminal 434A, 434B, 434C.

The second switch 430 also includes a plurality of second NMOS transistors 435D, 435E, wherein a source terminal of each second NMOS transistor 435D, 435E is connected to the second reference terminal 431, and a drain terminal of each second NMOS transistor 435D, 435E is connected to the source terminal of one first NMOS transistor 433A, 433B, 433C and the drain terminal of its adjacent first NMOS transistor 433A, 433B, 433C. In this way, one second NMOS transistor 435D, 435E is connected between each pair of first NMOS transistors 433A, 433B, 433C. In this example, the plurality of second NMOS transistors 435D, 435E includes two second NMOS transistors 435D, 435E, but other numbers of second NMOS transistors are possible. Therefore, in this example, the drain terminal of a first transistor 435D of the second NMOS transistors is connected to the drain terminal of the first 432A of the first NMOS transistors and the source terminal of the second 432B of the first NMOS transistors. The drain terminal of the second 435E of the second NMOS transistors is connected to the drain terminal of the second 432B of the first NMOS transistors and the source terminal of the final transistor 432C of the first NMOS transistors. A gate terminal of each second NMOS transistor 435D, 435E is connected to the second switch control terminal 434E, 434D.

The second switch control terminal shown separately as terminals 434A, 434B, 434C, 434D, 434E associated with each transistor of the second switch 430 may either be controlled independently, or together with each other second switch control terminal 434A, 434B, 434C, 434D, 434E. In this example, the second switch control terminals 434A, 434B, 434C, 434D, 434E are all controlled together. When the apparatus is in the transmit mode, the second switch 430 is open such that one or more signals which are provided to the second switch control terminals 434A, 434B, 434C, 434D, 434E are configured to cause the plurality of first NMOS transistors 432A, 432B, 432C and the plurality of second NMOS transistors 435D, 435E to not conduct. When the apparatus is in the receive mode, the second switch 430 is closed such that one or more signals which are provided to the second switch control terminals 434A, 434B, 434C, 434D, 434E are configured to cause the plurality of first NMOS transistors 432A, 432B, 432C and the plurality of second NMOS transistors to conduct 435D, 435E. The one or more signals may be provided to the second switch control terminals 434A, 434B, 434C, 434D, 434E by a controller (not shown) or any other suitable means. The controller may be the same controller as a controller which is used to control the transmission and / or receipt of signals.

In some examples, the apparatus may, in addition to a receive mode and a transmit mode, be configured to operate in a fast-settle mode. The apparatus may be configured to operate in the fast-settle mode when the transmitter is configured to transmit a signal from the antenna, and the receiver is configured to receive a signal from the antenna within a short period of time from transmission. For example, the received signal may be a reflection of the signal which was transmitted from the antenna. In order to facilitate this mode without risking damage to any components, the first switch 220 and the second switch 230 are controlled such that the first switch 220 and the second switch 230 are configured to be open while the transmitter is transmitting a signal from the antenna, and the first switch and the second switch are configured to be closed while the receiver is receiving a signal from the antenna. As mentioned above, the time between transmission and receipt of a signal may be too short such that the time needed to switch between the transmission mode and receive mode, as described above, is too long for the apparatus to be able to receive the signal. For example, if the transmitted signals are radar signals and if a target is close to the antenna, such that the reflection from the target is received a very short time after transmission. Thus, it may be advantageous for the function switch to be capable of fast switching with low disruption to the receiver amplifier arrangement.

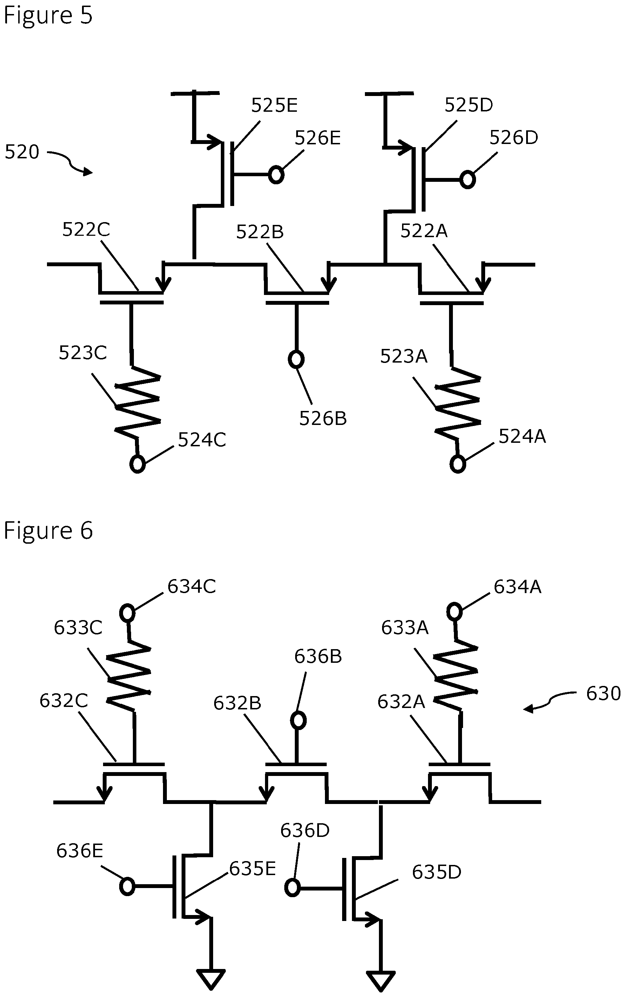

The embodiments described in relation to Figures 5-7 below are capable of "blanking" the LNA circuit 140 for a very short period of time, thereby allowing the transmitter to transmit with high power and the receiver to receive subsequently with high sensitivity, without damaging the LNA circuit or saturating the receiver chain. In particular, the function switch is controlled in a way to "blank" the receiver amplifier arrangement (e.g. the LNA circuit 140, 240) during transmission with low disruption to a bias point of the receiver amplifier arrangement 140, 240.

Figure 5 shows an example first switch 520 which is configured to operate in the transmit mode, the receive mode and the fast-settle mode, according to an embodiment of the present disclosure. The first switch 520 includes a plurality of transistors 522A, 522B, 522C, 522D, 522E. When the apparatus is in the transmission mode, all of the plurality of transistors 522A, 522B, 522C, 522D, 522E are configured to not conduct. When the apparatus is in the receive mode, all of the plurality of transistors 522A, 522B, 522C, 522D, 522E are configured to conduct. When the apparatus is in the fast-settle mode, some of the plurality of transistors 522A, 522B, 522C, 522D, 522E are configured to conduct, and some of the plurality of transistors 522A, 522B, 522C, 522D, 522E are configured to not conduct.

As is clear from the figure, the first switch 520 for operation within the fast-settle mode in this embodiment is very similar to the first switch described with reference to Figure 3. However, where in the first switch of Figure 3, the gate terminal of each of the plurality of first PMOS transistors is connected to a first terminal of a respective resistor (and wherein a second terminal of the respective resistor is connected to a first switch control terminal), in this embodiment, gate terminals of only the first 522A of the plurality of first PMOS transistors and the final 522C of the first PMOS transistors in the chain are connected to a first terminal of a respective resistor 523A, 523C (and wherein a second terminal of the respective resistor is connected to a first switch control terminal 524A, 524C). A gate terminal of each other first PMOS transistor (in this example the second 522B of the first PMOS transistors) is connected to a first switch blanking control terminal 526B. A gate terminal of each second PMOS transistor 525D, 525E is connected to a first switch blanking control terminal 526E, 526E. The lack of a respective resistor between the first PMOS transistors 522B which are not the first or the final transistors in the chain and the first switch blanking control terminal 526B increases the speed with which the first switch 520 settles, and therefore helps to facilitate the fast-settle mode of the apparatus. This is because settling time is proportional to resistance. By eliminating the relatively large resistor between the first PMOS transistors 522B which are not the first or the final transistors in the chain and the first switch blanking control terminal, only parasitic resistance remains in this path and so the settling time has been found to be fast. In this example, the plurality of first PMOS transistors 522A, 522B, 522C includes three first PMOS transistors 522A, 522B, 522C, and the plurality of second PMOS transistors 525D, 525E includes two second PMOS transistors 525D, 525E, but other numbers of transistors are possible.

When the apparatus is in the transmit mode, the first switch 520 is open such that one or more signals which are provided to the first switch control terminals are configured to cause the first 522A of the plurality of first PMOS transistors in the chain and the final 522C first PMOS transistor in the chain to not conduct. One or more signals which are provided to the first switch blanking control terminals are configured to cause each other first PMOS transistor of the plurality of series PMOS transistors (in this example the second 522B of the first PMOS transistors) and the plurality of second PMOS transistors 525D, 525E to not conduct.

When the apparatus is in the receive mode, the first switch 520 is closed such that one or more signals which are provided to the first switch control terminals 524A, 524C are configured to cause the first 522A of the plurality of first PMOS transistors in the chain and the final 522C first PMOS transistor in the chain to conduct. One or more signals which are provided to the first switch blanking control terminals are configured to cause each other first PMOS transistor of the plurality of series PMOS transistors (in this example the second 522B of the first PMOS transistors) and the plurality of second PMOS transistors 525D, 525E to conduct.

When the apparatus is in the fast-settle mode, one or more signals which are provided to the first switch blanking control terminals 526B, 526D, 526E are configured to cause all of the first PMOS transistors apart from the first and final transistors of the first PMOS transistors in the chain (in this example the second 522B of the first PMOS transistors) and the second PMOS transistors 525D, 525E to not conduct while the transmitter is transmitting a signal from the antenna. One or more signals which are provided to the first switch control terminals 524A, 524C are also configured to cause the first 522A and final 522C of the first PMOS transistors in the chain to conduct while the transmitter is transmitting a signal from the antenna. One or more signals which are provided to the first switch blanking control terminals 526B, 526D, 526E are configured to cause all of the first PMOS transistors apart from the first and final of the first PMOS transistors in the chain (in this example the second 522B of the first PMOS transistors) and the second PMOS transistors 525D, 525E to conduct while the receiver amplifier arrangement is receiving a signal from the antenna. One or more signals which are provided to the first switch control terminals 524A, 524C are also configured to cause the first 522A and final 522C of the first PMOS transistors in the chain to conduct while the transmitter is receiving a signal from the antenna. In other words, the first switch blanking control terminals 526B, 526D, 526E are controlled dynamically for LNA blanking. The first switch control terminal 524A, 524C and the first switch blanking control terminals 526B, 526D, 526E may be controlled by a controller (not shown) or any other suitable means. The controller may be the same controller as a controller which is used to control the transmission and / or receipt of signals.

Figure 6 shows an example second switch 630 which is configured to operate in the transmit mode, the receive mode and the fast-settle mode, according to an embodiment of this disclosure. The second switch 630 includes a plurality of transistors 632A, 632B, 632C, 632D, 632E. When the apparatus is in the transmission mode, all of the plurality of transistors 632A, 632B, 632C, 632D, 632E are configured to not conduct. When the apparatus is in the receive mode, all of the plurality of transistors 632A, 632B, 632C, 632D, 632E are configured to conduct. When the apparatus is in the fast-settle mode, some of the plurality of transistors 632A, 632B, 632C, 632D, 632E are configured to conduct, and some of the plurality of transistors 632A, 632B, 632C, 632D, 632E are configured to not conduct.

As is clear from the figure, the second switch 630 for operation within the fast-settle mode in this embodiment is very similar to the second switch described with reference to Figure 4. However, wherein the second switch of Figure 4, the gate terminal of each of the plurality of first NMOS transistors is connected to the first terminal of a respective resistor (and wherein a second terminal of the respective resistor is connected to a second switch control terminal), in this embodiment, gate terminals of only the first 632A of the plurality of first NMOS transistors and the final 632C of the plurality of first PMOS transistors in the chain are connected to a first terminal of a respective resistor 633A, 633C (and wherein a second terminal of the respective resistor is connected to a second switch control terminal 634A, 634C). A gate terminal of each other first NMOS transistor (in this example the second 632B of the first NMOS transistors) is connected to a second switch blanking control terminal 636B. A gate terminal of each second NMOS transistor 635D, 635E is connected to a second switch blanking control terminal 636E, 636E. The lack of a respective resistor between the first NMOS transistors 632B which are not the first or the final transistors in the chain and the second switch blanking control terminal 636B increases the speed with which the second switch 630 settles, and therefore helps to facilitate the fast-settle mode of the apparatus. Similarly to the example first switch shown in Figure 5, in this example, the plurality of first NMOS transistors 632A, 632B, 632C includes three first NMOS transistors 632A, 632B, 632C, and the plurality of second NMOS transistors 635D, 635E includes two second NMOS transistors 635D, 635E, but other numbers of transistors are possible.

When the apparatus is in the transmit mode, the second switch 630 is open such that one or more signals which are provided to the second switch control terminals are configured to cause the first 632A of the plurality of first NMOS transistors in the chain and the final 632C of the first NMOS transistors in the chain to not conduct. One or more signals which are provided to the second switch blanking control terminals are configured to cause each other first PMOS transistor of the plurality of series NMOS transistors (in this example the second 632B of the first NMOS transistors) and the plurality of second NMOS transistors 635D, 635E to not conduct.

When the apparatus is in the receive mode, the second switch 630 is closed such that one or more signals which are provided to the second switch control terminals 634A, 634C are configured to cause the first 632A of the plurality of first NMOS transistors in the chain and the final 632C of the first NMOS transistors in the chain to conduct. One or more signals which are provided to the second switch blanking control terminals are configured to cause each other first NMOS transistor of the plurality of series NMOS transistors (in this example the second 632B of the first NMOS transistors) and the plurality of second NMOS transistors 635D, 635E to conduct.

When the apparatus is in the fast-settle mode, one or more signals which are provided to the second switch blanking control terminals 636B, 636D, 636E are configured to cause all of the first NMOS transistors apart from the first and final of the first NMOS transistors in the chain (in this example the second 632B of the first NMOS transistors) and the second NMOS transistors 635D, 635E to not conduct while the transmitter is transmitting a signal from the antenna. One or more signals which are provided to the second switch control terminals 634A, 634C are also configured to cause the first 632A and final 632C of the first NMOS transistors in the chain to conduct while the transmitter is transmitting a signal from the antenna. One or more signals which are provided to the second switch blanking control terminals 636B, 636D, 636E are configured to cause all of first NMOS transistors apart from the first and the final of the first NMOS transistors in the chain (in this example the second 632B of the first NMOS transistors) and the second NMOS transistors 635D, 635E to conduct while the receiver is receiving a signal from the antenna. One or more signals which are provided to the second switch control terminals 634A, 634C are also configured to cause the first 632A and final 632C of the first NMOS transistors in the chain to conduct while the transmitter is receiving a signal from the antenna. In other words, the second switch blanking control terminals 636B, 636D, 636E are controlled dynamically for LNA blanking.

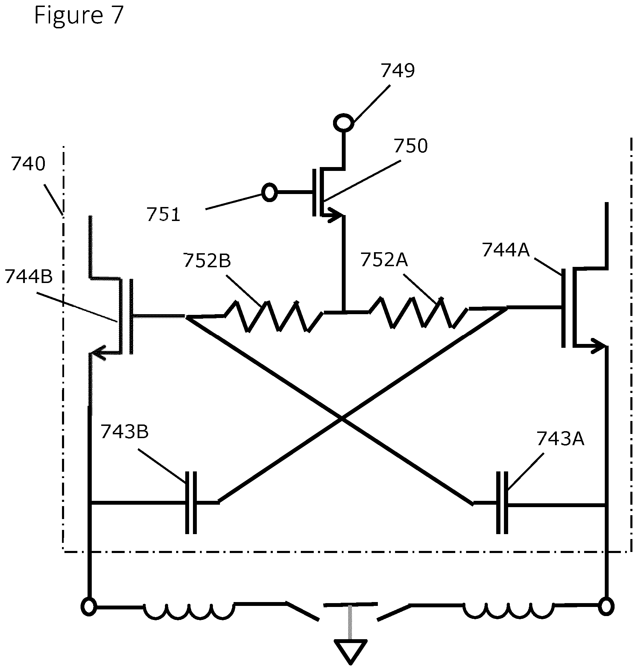

Figure 7 shows the second part of an example LNA circuit 740 which is configured to operate in the fast-settle mode, according to an embodiment of this disclosure. In addition to the components described with reference to Figure 2, the second part of the LNA circuit 740 includes a second-part blanking supply voltage terminal 749 configured to provide a second-part blanking supply voltage. In one or more embodiments, the second-part blanking supply voltage is equal to the LNA supply voltage. The second part of the LNA circuit 740 also includes a second-part blanking transistor 750 with a drain terminal connected to the second-part blanking supply voltage terminal 749, a source terminal connected to the first terminal of the second-part first capacitor 743B and the first terminal of the second-part second capacitor 743A and a gate terminal connected to a second-part blanking control terminal 751. That is, the source terminal of the second-part blanking transistor 750 is connected to the gate terminals of both of the pair of NMOS transistors 744A, 744B. In this example, the second part of the example LNA circuit 740 also includes a pair of resistors 752A, 752B. A first terminal of a first resistor 752A of the pair of resistors is connected to the source terminal of the second-part blanking transistor 750, and a second terminal of the first resistor 752A is connected to the second terminal of the second-part first capacitor 743B. A first terminal of a second resistor 752B of the pair of resistors is connected to the source terminal of the second-part blanking transistor 750, and a second terminal of the second resistor 752A is connected to the second terminal of the second-part second capacitor 743A. In this way, the pair of resistors 752A, 752B are also connected between the gate terminals of the pair of NMOS transistors 744A, 744B. The pair of resistors 752A, 752B provide a DC path for the LNA, which defines the operating point of the pair of NMOS transistors 744A, 744B.

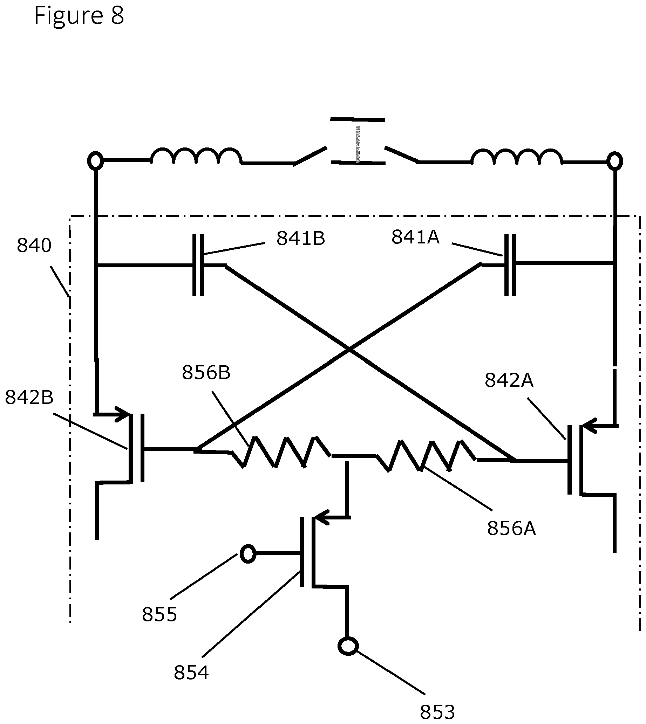

In this example, the first part of the LNA circuit 740 includes a corresponding set of features. Figure 8 shows the first part of an example LNA circuit 840 which is configured to operate in the fast-settle mode, according to an embodiment of this disclosure.

In addition to the components described with reference to Figure 2, the first part of the LNA circuit 840 includes a first-part blanking supply voltage terminal 853 configured to provide a first-part blanking supply voltage. In one or more embodiments, the first-part blanking supply voltage is equal to the LNA supply voltage. The first part of the LNA circuit 840 also includes a first-part blanking transistor 854 with a drain terminal connected to the first-part blanking supply voltage terminal 853, a source terminal connected to the first terminal of the first-part first capacitor 841B and the first terminal of the first-part second capacitor 841A and a gate terminal connected to a first-part blanking control terminal 855. That is, the source terminal of the first-part blanking transistor 854 is connected to the gate terminals of both of the pair of PMOS transistors 842A, 842B. In this example, the first part of the example LNA circuit 740 also includes a pair of resistors 856A, 856B. A first terminal of a first resistor 856A of the pair of resistors is connected to the source terminal of the first-part blanking transistor 854, and a second terminal of the first resistor 856A is connected to the second terminal of the first-part first capacitor 841B. A first terminal of a second resistor 856B of the pair of resistors is connected to the source terminal of the first-part blanking transistor 854, and a second terminal of the second resistor 752A is connected to the second terminal of the first-part second capacitor 841A. In this way, the pair of resistors 856A, 856B are also connected between the gate terminals of the pair of PMOS transistors 842A, 842B. The pair of resistors 856A, 856B provide a DC path for the LNA, which defines the operating point of the pair of PMOS transistors 842A, 842B.

When the apparatus is in the transmit mode, one or more signals which are provided to the first-part blanking control terminal 855 and the second-part blanking control terminal 751 are configured to cause the first-part blanking transistor 854 and the second-part blanking transistor 750 to not conduct. In this way, the LNA-blanking-related components in the LNA circuit 740 do not affect the ability of the LNA circuit 740 to operate as normal within the transmit mode.

When the apparatus is in the receive mode, one or more signals which are provided to the first-part blanking control terminal 855 and the second-part blanking control terminal 751 are configured to cause the first-part blanking transistor 854 and the second-part blanking transistor 750 to conduct. In this way, the LNA-blanking-related components in the LNA circuit 740 do not affect the ability of the LNA circuit 740 to operate as normal within the receive mode.

When the apparatus is in the fast-settle mode, while the apparatus is providing signalling to the antenna, the receiver amplifier arrangement 740 is configured to cause the first-part blanking transistor 854 and the second-part blanking transistor 750 to not conduct, such that charge over the first plurality of capacitors 841A, 841B and the second plurality of capacitors 743A, 743B remains unchanged/undisturbed for maintaining the bias point for the LNA circuit. In this way, the receiver amplifier arrangement 740 can more quickly return to a state in which the receiver amplifier arrangement 740 can receive signalling from the amplifier.

More specifically, when the apparatus is in the fast-settle mode: one or more signals which are provided to the first-part blanking control terminal 855 and the second-part blanking control terminal 751 are configured to cause the first-part blanking transistor 854 and the second-part blanking transistor 750 to not conduct while the transmitter is transmitting a signal from the antenna, such that charge over the first-part first capacitor 841B and the first-part second capacitor 841A, and the charge over the second-part first capacitor 743B and the second-part second capacitor 743A remains unchanged. One or more signals which are provided to the first-part blanking control terminal 855 and the second-part blanking control terminal 751 are configured to cause the first-part blanking transistor 854 and the second-part blanking transistor 750 to conduct while the receiver is receiving a signal from the antenna. In this example, one or more signals which are provided to the first-part blanking control terminal and the second-part blanking control terminal 751 are configured to cause the first-part blanking transistor and the second-part blanking transistor 750 to conduct at the same time as one or more signals which are provided to the first switch blanking control terminals and the second switch blanking control terminals are configured to cause their respective transistors to conduct. In this way, the LNA circuit 740 is able to receive the signalling from the antenna.

Advantageously, because the charge over the first-part cross coupled capacitors and the second-part cross coupled capacitors 743A, 743B remains unchanged during the temporary LNA blank for transmission, fast settling can be achieved such that the LNA circuit 740 can turn back on and start receiving the reflected signal more quickly than it otherwise could. This reduction in switching time can reduce the "blind zone" of undetectable reflections wherein the term "blind zone" refers to situations wherein a reflecting object is too close to the antenna for the apparatus to switch between transmit and receive modes quickly enough. In this way, the "blind zone" defines a region in which a radar antenna cannot detect reflections.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. An apparatus comprising:
an antenna pin for coupling to an antenna, the antenna pin coupled to at least a first antenna inductor in series with a second antenna inductor, wherein the second antenna inductor is further coupled to a first reference pin configured to provide a first reference voltage;
a first set of differential input-output pins comprising a first input-output pin and second input-output pin, wherein the first input-output pin is coupled to a first inductor in series with a second inductor, and wherein the second inductor is further coupled to the second input-output pin, wherein the apparatus further comprises a first supply terminal coupled between the first inductor and the second inductor to receive a first supply voltage, wherein
the first inductor is configured to magnetically couple with the first antenna inductor and the second inductor is configured to magnetically couple with the second antenna inductor for transmission of signalling received at the first set of differential input-output pins from the antenna when it is coupled to the antenna pin; and
a function switch, comprising:
a second set of differential input-output pins, comprising a third input-output pin and fourth input-output pin, wherein the third input-output pin is coupled to a third inductor in series with a fourth inductor, and wherein the fourth inductor is further coupled to the fourth input-output pin, and wherein the function switch comprises a first switch between the third inductor and the fourth inductor, wherein
the third inductor is configured to magnetically couple with the first antenna inductor and the fourth inductor is configured to magnetically couple with the second antenna inductor for provision of signalling received from the antenna pin to the second set of differential input-output pins;
a third set of differential input-output pins, comprising a fifth input-output pin and sixth input-output pin, wherein the fifth input-output pin is coupled to a fifth inductor in series with a sixth inductor, and wherein the sixth inductor is further coupled to the sixth input-output pin, and wherein the function switch comprises a second switch between the fifth inductor and the sixth inductor, wherein
the fifth inductor is configured to magnetically couple with the first antenna inductor and the sixth inductor is configured to magnetically couple with the second antenna inductor for provision of signalling received from the antenna pin to the third set of differential input-output pins.

2. The apparatus of claim 1, including a receiver amplifier arrangement, wherein the second set of differential input-output pins and the third set of differential input-output pins are configured to be connected to the receiver amplifier arrangement that is configured to receive the signalling received from the antenna via the antenna pin, wherein the receiver amplifier arrangement comprises a first part formed of at least a pair of PMOS transistors and a second part formed of at least a pair of NMOS transistors.

3. The apparatus of claim 2, wherein:
the second set of differential input-output pins are connected to the first part of the receiver amplifier arrangement; and
the third set of differential input-output pins are connected to the second part of the receiver amplifier arrangement.

4. The apparatus of any preceding claim, wherein:
the first switch is connected to a second supply terminal which is configured to receive a second supply voltage, such that when the first switch is closed, the third inductor and the fourth inductor receive the second supply voltage, and when the first switch is open, the third inductor is not connected to the fourth inductor; and
the second switch is connected to a second reference terminal configured to receive a second reference voltage, such that when the second switch is closed, the fifth inductor and the sixth inductor receive the second reference voltage, and when the second switch is open, the fifth inductor is not connected to the sixth inductor.

5. The apparatus of any preceding claim, wherein the apparatus is configured to operate in a transmit mode and a receive mode wherein:
when the apparatus is in the transmit mode, the first switch and the second switch are configured to be open, and the apparatus is configured to receive signalling for transmission from the first set of differential input-output pins; and
when the apparatus is in the receive mode, the first switch and the second switch are configured to be closed, and the apparatus is configured to provide signalling received via the antenna pin to the second and third set of differential input-output pins, such that the second and third sets of differential input-output pins are configured to provide the signalling as a differential signal to a receiver amplifier arrangement.

6. The apparatus of any preceding claim, wherein:
the first switch comprises a plurality of transistors configured to provide an open or non-conducting state and a closed or conducting state for individually controlling the impedance between the third inductor and the fourth inductor; and
the second switch comprises a plurality of transistors configured to provide an open or non-conducting state and a closed or conducting state for individually controlling the impedance between the fifth inductor and the sixth inductor.

7. The apparatus of claim 6, wherein the apparatus is configured to operate in a fast-settle mode, wherein when the apparatus is in the fast-settle mode:
while the apparatus is providing signalling to the antenna:
one or more of the plurality of transistors of the first switch are configured to be open;
one or more of the plurality of transistors of the first switch are configured to be closed;
one or more of the plurality of transistors of the second switch are configured to be open; and
one or more of the plurality of transistors of the second switch are configured to be closed;
while the apparatus is receiving signalling from the antenna:
all of the plurality of transistors in the first switch are configured to be closed; and
all of the plurality of transistors in the second switch are configured to be closed.

8. The apparatus of any preceding claim, wherein:
the first switch comprises:
a plurality of first PMOS transistors, connected in series in a chain such that a source terminal of one first PMOS transistor is connected to a drain terminal of an adjacent first PMOS transistor in the chain, wherein
the source terminal of a first of the plurality of first PMOS transistors in the chain is connected to the third inductor, and the drain terminal of a final first PMOS transistor in the chain is connected to the fourth inductor, and
a gate terminal of each of the first PMOS transistors is connected to a first terminal of a respective resistor and wherein a second terminal of the respective resistor is connected to a first switch control terminal; and
a plurality of second PMOS transistors, wherein
a source terminal of each second PMOS transistor is connected to the second supply terminal, and a drain terminal of each second PMOS transistor is connected to the source terminal of one first PMOS transistor and the drain terminal of its adjacent first PMOS transistor, such that one second PMOS transistor is connected between each pair of first PMOS transistors, and
a gate terminal of each second PMOS transistor is connected to a first switch control terminal;
the second switch comprises:
a plurality of first NMOS transistors, connected in series in a chain such that a source terminal of one first NMOS transistor is connected to a drain terminal of the adjacent first NMOS transistor, wherein
the source terminal of a first of the plurality of first NMOS transistors in the chain is connected to the fifth inductor, and the drain terminal of a final first NMOS transistor in the chain is connected to the sixth inductor, and
a gate terminal of each of the first NMOS transistors is connected to a first terminal of a respective resistor and wherein a second terminal of the respective resistor is connected to a second switch control terminal; and
a plurality of second NMOS transistors, wherein
a source terminal of each second NMOS transistor is connected to the second reference terminal, and a drain terminal of each second NMOS transistor is connected to the source terminal of one first NMOS transistor and the drain terminal of its adjacent first NMOS transistor, such that one second NMOS transistor is connected between each pair of first NMOS transistors, and
a gate terminal of each second NMOS transistor is connected to a second switch control terminal.

9. The apparatus of claim 8, wherein:
when the apparatus is in the transmit mode, the first switch is open such that one or more signals which are provided to the first switch control terminals are configured to cause the plurality of first PMOS transistors and the plurality of second PMOS transistors to not conduct, and the second switch is open such that one or more signals which are provided to the second switch control terminals are configured to cause the plurality of first NMOS transistors and the plurality of second NMOS transistors to not conduct; and
when the apparatus is in the receive mode, the first switch is closed such that one or more signals which are provided to the first switch control terminals are configured to cause the plurality of first PMOS transistors and the plurality of second PMOS transistors to conduct, and the second switch is closed such that one or more signals which are provided to the second switch control terminals are configured to cause the plurality of first NMOS transistors and the plurality of second NMOS transistors to conduct.

10. The apparatus of claim 8 or claim 9, wherein:
the plurality of first PMOS transistors comprises three first PMOS transistors;
the plurality of second PMOS transistors comprises two second PMOS transistors;
the plurality of first NMOS transistors comprises three first NMOS transistors; and
the plurality of second NMOS transistors comprises two second NMOS transistors.

11. The apparatus of any of claims 1 to 5, wherein:
the first switch comprises:
a plurality of first PMOS transistors, connected in series in a chain such that a source terminal of one first PMOS transistor is connected to a drain terminal of the adjacent first PMOS transistor, wherein
the source terminal of a first of the plurality of first PMOS transistors is connected to the third inductor, and the drain terminal a final first PMOS transistor in the chain is connected to the fourth inductor, and
a gate terminal of the first of the plurality of first PMOS transistors and a gate terminal of the final first PMOS transistor in the chain are connected to a first terminal of a respective resistor and wherein a second terminal of the respective resistor is connected to a first switch control terminal, and a gate terminal of each other first PMOS transistor is connected to a first switch blanking control terminal; and
a plurality of second PMOS transistors, wherein
a source terminal of each second PMOS transistor is connected to the second supply terminal, and a drain terminal of each second PMOS transistor is connected to the source terminal of one first PMOS transistor and the drain terminal of its adjacent first PMOS transistor, such that one second PMOS transistor is connected between each pair of first PMOS transistors, and
a gate terminal of each second PMOS transistor is connected to a first switch blanking control terminal;
the second switch comprises:
a plurality of first NMOS transistors, connected in series in a chain such that a source terminal of one first NMOS transistor is connected to a drain terminal of the adjacent series NMOS transistor, wherein
the source terminal of a first of the plurality of first NMOS transistors is connected to the fifth inductor, and the drain terminal of a final first NMOS transistor in the chain is connected to the sixth inductor, and
a gate terminal of the first of the plurality of first NMOS transistors and a gate terminal of the final first NMOS transistor in the chain is connected to a first terminal of a respective resistor, and wherein a second terminal of the respective resistor is connected to a second switch control terminal, and a gate terminal of each other first NMOS transistor is connected to a second switch blanking control terminal; and
a plurality of second NMOS transistors, wherein
a source terminal of each second NMOS transistor is connected to the second reference terminal, and a drain terminal of each second NMOS transistor is connected to the source terminal of one first NMOS transistor and the drain terminal of its adjacent first NMOS transistor, such that one second NMOS transistor is connected between each pair of first NMOS transistors, and
a gate terminal of each second NMOS transistor is connected to a second switch blanking control terminal.

12. The apparatus of claim 11, wherein:
when the apparatus is in the transmit mode:
the first switch is open such that one or more signals which are provided to the first switch control terminals are configured to cause the first of the plurality of first PMOS transistors in the chain and the final first PMOS transistor in the chain to not conduct, and one or more signals which are provided to the first switch blanking control terminals are configured to cause each other first PMOS transistor of the plurality of first PMOS transistors and the plurality of second PMOS transistors to not conduct; and
the second switch is open such that one or more signals which are provided to the second switch control terminals are configured to cause the first of the plurality of first NMOS transistors in the chain and the final first NMOS transistor in the chain to not conduct, and one or more signals which are provided to the second switch blanking control terminals are configured to cause each other first NMOS transistor of the plurality of first NMOS transistors and the plurality of second NMOS transistors to not conduct; and
when the apparatus is in the receive mode:
the first switch is open such that one or more signals which are provided to the first switch control terminals are configured to cause the first of the plurality of first PMOS transistors and the final first PMOS transistor in the chain to conduct, and one or more signals which are provided to the first switch blanking control terminals are configured to cause each other first PMOS transistor of the plurality of first PMOS transistors and the plurality of second PMOS transistors to conduct; and
the second switch is open such that one or more signals which are provided to the second switch control terminals are configured to cause the first of the plurality of first NMOS transistors in the chain and the final first NMOS transistor in the chain to conduct, and one or more signals which are provided to the second switch blanking control terminals are configured to cause each other first NMOS transistor of the plurality of first NMOS transistors and the plurality of parallel NMOS transistors to conduct;
when the apparatus is in the fast-settle mode:
one or more signals which are provided to the first switch blanking control terminals and the second switch blanking control terminals are configured to cause one or more of the first PMOS transistors apart from the first and final first PMOS transistors in the chain, one or more of the first NMOS transistors apart from the first and final first NMOS transistors in the chain, the second PMOS transistors and the second NMOS transistors to not conduct, and one or more signals which are provided to the first switch control terminals and the second switch control terminals are configured to cause the first and final first PMOS transistors in the chain and the first and final first NMOS transistors in the chain to conduct, while the apparatus is providing signalling to the antenna, and
one or more signals which are provided to the first switch blanking control terminals and the second switch blanking control terminals are configured to cause one or more of the first PMOS transistors apart from the first and final first PMOS transistors in the chain, one or more of the first NMOS transistors apart from the first and final first NMOS transistors in the chain, the second PMOS transistors and the second NMOS transistors to conduct, and one or more signals which are provided to the first switch control terminals and the second switch control terminals are configured to cause the first and last first PMOS transistors in the chain and the first and final first NMOS transistors in the chain to conduct, while the apparatus is receiving signalling from the antenna.

13. The apparatus of claim 2 or claim 3, wherein the receiver amplifier arrangement further comprises:
a first plurality of capacitors configured to, at least in part, cancel noise within the receiver amplifier arrangement;
a second plurality of capacitors configured to configured to, at least in part, cancel noise within the receiver amplifier arrangement;
one or more blanking supply voltage terminals configured to provide one or more blanking supply voltages; wherein
during the fast-settle mode, while the apparatus is receiving signalling from the antenna, the receiver amplifier arrangement is configured to provide the one or more blanking supply voltages to the first plurality of capacitors and the second plurality of capacitors.

14. The apparatus of claim 2 or claim 3, wherein:
a first PMOS transistor of the pair of PMOS transistors comprises:
a source terminal coupled to the third differential input-output pin;
a drain terminal coupled to a first output terminal;
a gate terminal coupled to a first terminal of a first-part first capacitor, wherein a second terminal of the first-part first capacitor is coupled to the fourth differential input-output pin;
a second PMOS transistor of the pair of PMOS transistors comprises:
a source terminal coupled to the fourth differential input-output pin;
a drain terminal coupled to a second output terminal;
a gate terminal coupled to a first terminal of a first-part second capacitor, wherein a second terminal of the first-part second capacitor is coupled to the third differential input-output pin;
the first part of the low noise amplifier circuit further comprises:
a first-part blanking supply voltage terminal configured to provide a first-part blanking supply voltage; and
a first-part blanking transistor with a drain terminal connected to the first-part blanking supply voltage terminal, a source terminal connected to the first terminal of the first-part first capacitor and the first terminal of the first-part second capacitor and a gate terminal connected to a first-part blanking control terminal;
a first NMOS transistor of the pair of NMOS transistors comprises:
a source terminal coupled to the fifth differential input-output pin;
a drain terminal coupled to the first output terminal;
a gate terminal coupled to a first terminal of a second-part first capacitor, wherein a second terminal of the second-part first capacitor is coupled to the sixth differential input-output pin;
a second NMOS transistor of the pair of NMOS transistors comprises:
a source terminal coupled to the sixth differential input-output pin;
a drain terminal coupled to the second output terminal;
a gate terminal coupled to a first terminal of a second-part second capacitor, wherein a second terminal of the second-part first capacitor is coupled to the fifth differential input-output pin;
the second part of the low noise amplifier circuit further comprises:
a second-part blanking supply voltage terminal configured to provide a second-part blanking supply voltage; and
a second-part blanking transistor with a drain terminal connected to the fourth supply voltage terminal, a source terminal connected to the first terminal of the second-part first capacitor and the first terminal of the second-part second capacitor and a gate terminal connected to a second-part blanking control terminal.

15. The apparatus of claim 14, wherein:
when the apparatus is in the transmit mode, one or more signals which are provided to the first-part blanking control terminal and the second-part blanking control terminal are configured to cause the first-part blanking transistor and the second-part blanking transistor to not conduct;
when the apparatus is in the receive mode, one or more signals which are provided to the first-part blanking control terminal and the second-part blanking control terminal are configured to cause the first-part blanking transistor and the second-part blanking transistor to conduct; and
when the apparatus is in the fast-settle mode:
one or more signals which are provided to the first-part blanking control terminal and the second-part blanking control terminal are configured to cause the first-part blanking transistor and the second-part blanking transistor to not conduct while the apparatus is providing signalling to the antenna, such that charge over the first-part first capacitor and the first-part second capacitor and the charge over the second-part first capacitor and the second-part second capacitor remains unchanged, and
one or more signals which are provided to the first-part blanking control terminal and the second-part blanking control terminal are configured to cause the first-part blanking transistor and the second-part blanking transistor to conduct while the receiver amplifier arrangement is receiving signalling from the antenna pin.

## Amended claims

### Amended claims in accordance with Rule 137(2) EPC.

1. An apparatus (100) comprising:
an antenna pin (101) for coupling to an antenna, the antenna pin (101) coupled to at least a first antenna inductor (102A) in series with a second antenna inductor (102B), wherein the second antenna inductor (102B) is further coupled to a first reference pin (103) configured to provide a first reference voltage;
a first set of differential input-output pins comprising a first input-output pin (104A) and second input-output pin (104B), wherein the first input-output pin (104A) is coupled to a first inductor (105A) in series with a second inductor (105B), and wherein the second inductor (105B) is further coupled to the second input-output pin (104B), wherein the apparatus (100) further comprises a first supply terminal (106) coupled between the first inductor (105A) and the second inductor (105B) to receive a first supply voltage, wherein
the first inductor (105A) is configured to magnetically couple with the first antenna inductor (102A) and the second inductor (105B) is configured to magnetically couple with the second antenna inductor (102B) for transmission of signalling received at the first set of differential input-output pins from the antenna when it is coupled to the antenna pin (101); and
a function switch (160), comprising:
a second set of differential input-output pins, comprising a third input-output pin (107A) and fourth input-output pin (107B), wherein the third input-output pin (107A) is coupled to a third inductor (108A) in series with a fourth inductor (108B), and wherein the fourth inductor (108B) is further coupled to the fourth input-output pin (107B), and wherein the function switch (160) comprises a first switch (120) between the third inductor (108A) and the fourth inductor (108B), wherein
the third inductor (108A) is configured to magnetically couple with the first antenna inductor (102A) and the fourth inductor (108B) is configured to magnetically couple with the second antenna inductor (102B) for provision of signalling received from the antenna pin (101) to the second set of differential input-output pins;
a third set of differential input-output pins, comprising a fifth input-output pin (109A) and sixth input-output pin (109B), wherein the fifth input-output pin (109A) is coupled to a fifth inductor (110A) in series with a sixth inductor (110B), and wherein the sixth inductor (110B) is further coupled to the sixth input-output pin (109B), and wherein the function switch (160) comprises a second switch (130) between the fifth inductor (110A) and the sixth inductor (110B), wherein
the fifth inductor (110A) is configured to magnetically couple with the first antenna inductor (102A) and the sixth inductor (110B) is configured to magnetically couple with the second antenna inductor (102B) for provision of signalling received from the antenna pin (101) to the third set of differential input-output pins.

2. The apparatus (100) of claim 1, including a receiver amplifier arrangement, wherein the second set of differential input-output pins and the third set of differential input-output pins are connected to the receiver amplifier arrangement that is configured to receive the signalling received from the antenna via the antenna pin (101), wherein the receiver amplifier arrangement comprises a first part formed of at least a pair of PMOS transistors and a second part formed of at least a pair of NMOS transistors.

3. The apparatus (100) of claim 2, wherein:
the second set of differential input-output pins are connected to the first part of the receiver amplifier arrangement; and
the third set of differential input-output pins are connected to the second part of the receiver amplifier arrangement.

4. The apparatus (100) of any preceding claim, wherein:
the first switch (120) is connected to a second supply terminal which is configured to receive a second supply voltage, such that when the first switch (120) is closed, the third inductor (108A) and the fourth inductor (108B) receive the second supply voltage, and when the first switch (120) is open, the third inductor (108A) is not connected to the fourth inductor (108B); and
the second switch (130) is connected to a second reference terminal configured to receive a second reference voltage, such that when the second switch (130) is closed, the fifth inductor (110A) and the sixth inductor (110B) receive the second reference voltage, and when the second switch (130) is open, the fifth inductor (110A) is not connected to the sixth inductor (110B).

5. The apparatus (100) of any preceding claim, wherein the apparatus (100) is configured to operate in a transmit mode and a receive mode wherein:
when the apparatus is in the transmit mode, the first switch (120) and the second switch (130) are configured to be open, and the apparatus (100) is configured to receive signalling for transmission from the first set of differential input-output pins; and
when the apparatus (100) is in the receive mode, the first switch (120) and the second switch (130) are configured to be closed, and the apparatus (100) is configured to provide signalling received via the antenna pin (101) to the second and third set of differential input-output pins, such that the second and third sets of differential input-output pins are configured to provide the signalling as a differential signal to a receiver amplifier arrangement.

6. The apparatus (100) of any preceding claim, wherein:
the first switch (120) comprises a plurality of transistors configured to provide an open or non-conducting state and a closed or conducting state for individually controlling the impedance between the third inductor (108A) and the fourth inductor (108B); and
the second switch (130) comprises a plurality of transistors configured to provide an open or non-conducting state and a closed or conducting state for individually controlling the impedance between the fifth inductor (110A) and the sixth inductor (110B).

7. The apparatus (100) of claim 6, wherein the apparatus (100) is configured to operate in a fast-settle mode, wherein when the apparatus (100) is in the fast-settle mode:
while the apparatus (100) is providing signalling to the antenna:
one or more of the plurality of transistors of the first switch (120) are configured to be open;
one or more of the plurality of transistors of the first switch (120) are configured to be closed;
one or more of the plurality of transistors of the second switch (130) are configured to be open; and
one or more of the plurality of transistors of the second switch (130) are configured to be closed;
while the apparatus (100) is receiving signalling from the antenna:
all of the plurality of transistors in the first switch (120) are configured to be closed; and
all of the plurality of transistors in the second switch (130) are configured to be closed.

8. The apparatus (100) of any preceding claim, wherein:
the first switch (120) comprises:
a plurality of first PMOS transistors, connected in series in a chain such that a source terminal of one first PMOS transistor is connected to a drain terminal of an adjacent first PMOS transistor in the chain, wherein
the source terminal of a first of the plurality of first PMOS transistors in the chain is connected to the third inductor (108A), and the drain terminal of a final first PMOS transistor in the chain is connected to the fourth inductor (108B), and
a gate terminal of each of the first PMOS transistors is connected to a first terminal of a respective resistor and wherein a second terminal of the respective resistor is connected to a first switch control terminal; and
a plurality of second PMOS transistors, wherein
a source terminal of each second PMOS transistor is connected to the second supply terminal, and a drain terminal of each second PMOS transistor is connected to the source terminal of one first PMOS transistor and the drain terminal of its adjacent first PMOS transistor, such that one second PMOS transistor is connected between each pair of first PMOS transistors, and
a gate terminal of each second PMOS transistor is connected to a first switch control terminal;
the second switch (130) comprises:
a plurality of first NMOS transistors, connected in series in a chain such that a source terminal of one first NMOS transistor is connected to a drain terminal of the adjacent first NMOS transistor, wherein
the source terminal of a first of the plurality of first NMOS transistors in the chain is connected to the fifth inductor (110A), and the drain terminal of a final first NMOS transistor in the chain is connected to the sixth inductor (110B), and
a gate terminal of each of the first NMOS transistors is connected to a first terminal of a respective resistor and wherein a second terminal of the respective resistor is connected to a second switch control terminal; and
a plurality of second NMOS transistors, wherein
a source terminal of each second NMOS transistor is connected to the second reference terminal, and a drain terminal of each second NMOS transistor is connected to the source terminal of one first NMOS transistor and the drain terminal of its adjacent first NMOS transistor, such that one second NMOS transistor is connected between each pair of first NMOS transistors, and
a gate terminal of each second NMOS transistor is connected to a second switch control terminal.

9. The apparatus (100) of claim 8, wherein:
when the apparatus (100) is in the transmit mode, the first switch (120) is open such that one or more signals which are provided to the first switch control terminals are configured to cause the plurality of first PMOS transistors and the plurality of second PMOS transistors to not conduct, and the second switch (130) is open such that one or more signals which are provided to the second switch control terminals are configured to cause the plurality of first NMOS transistors and the plurality of second NMOS transistors to not conduct; and
when the apparatus (100) is in the receive mode, the first switch (120) is closed such that one or more signals which are provided to the first switch control terminals are configured to cause the plurality of first PMOS transistors and the plurality of second PMOS transistors to conduct, and the second switch (130) is closed such that one or more signals which are provided to the second switch control terminals are configured to cause the plurality of first NMOS transistors and the plurality of second NMOS transistors to conduct.

10. The apparatus (100) of claim 8 or claim 9, wherein:
the plurality of first PMOS transistors comprises three first PMOS transistors;
the plurality of second PMOS transistors comprises two second PMOS transistors;
the plurality of first NMOS transistors comprises three first NMOS transistors; and
the plurality of second NMOS transistors comprises two second NMOS transistors.

11. The apparatus (100) of any of claims 1 to 5, wherein:
the first switch (120) comprises:
a plurality of first PMOS transistors, connected in series in a chain such that a source terminal of one first PMOS transistor is connected to a drain terminal of the adjacent first PMOS transistor, wherein
the source terminal of a first of the plurality of first PMOS transistors is connected to the third inductor (108A), and the drain terminal a final first PMOS transistor in the chain is connected to the fourth inductor (108B), and
a gate terminal of the first of the plurality of first PMOS transistors and a gate terminal of the final first PMOS transistor in the chain are connected to a first terminal of a respective resistor and wherein a second terminal of the respective resistor is connected to a first switch control terminal, and a gate terminal of each other first PMOS transistor is connected to a first switch blanking control terminal; and
a plurality of second PMOS transistors, wherein
a source terminal of each second PMOS transistor is connected to the second supply terminal, and a drain terminal of each second PMOS transistor is connected to the source terminal of one first PMOS transistor and the drain terminal of its adjacent first PMOS transistor, such that one second PMOS transistor is connected between each pair of first PMOS transistors, and
a gate terminal of each second PMOS transistor is connected to a first switch blanking control terminal;
the second switch (130) comprises:
a plurality of first NMOS transistors, connected in series in a chain such that a source terminal of one first NMOS transistor is connected to a drain terminal of the adjacent series NMOS transistor, wherein
the source terminal of a first of the plurality of first NMOS transistors is connected to the fifth inductor (110A), and the drain terminal of a final first NMOS transistor in the chain is connected to the sixth inductor (110B), and
a gate terminal of the first of the plurality of first NMOS transistors and a gate terminal of the final first NMOS transistor in the chain is connected to a first terminal of a respective resistor, and wherein a second terminal of the respective resistor is connected to a second switch control terminal, and a gate terminal of each other first NMOS transistor is connected to a second switch blanking control terminal; and
a plurality of second NMOS transistors, wherein
a source terminal of each second NMOS transistor is connected to the second reference terminal, and a drain terminal of each second NMOS transistor is connected to the source terminal of one first NMOS transistor and the drain terminal of its adjacent first NMOS transistor, such that one second NMOS transistor is connected between each pair of first NMOS transistors, and
a gate terminal of each second NMOS transistor is connected to a second switch blanking control terminal.

12. The apparatus (100) of claim 11, wherein:
when the apparatus (100) is in the transmit mode:
the first switch (120) is open such that one or more signals which are provided to the first switch control terminals are configured to cause the first of the plurality of first PMOS transistors in the chain and the final first PMOS transistor in the chain to not conduct, and one or more signals which are provided to the first switch blanking control terminals are configured to cause each other first PMOS transistor of the plurality of first PMOS transistors and the plurality of second PMOS transistors to not conduct; and
the second switch (130) is open such that one or more signals which are provided to the second switch control terminals are configured to cause the first of the plurality of first NMOS transistors in the chain and the final first NMOS transistor in the chain to not conduct, and one or more signals which are provided to the second switch blanking control terminals are configured to cause each other first NMOS transistor of the plurality of first NMOS transistors and the plurality of second NMOS transistors to not conduct; and
when the apparatus (100) is in the receive mode:
the first switch (120) is closed such that one or more signals which are provided to the first switch control terminals are configured to cause the first of the plurality of first PMOS transistors and the final first PMOS transistor in the chain to conduct, and one or more signals which are provided to the first switch blanking control terminals are configured to cause each other first PMOS transistor of the plurality of first PMOS transistors and the plurality of second PMOS transistors to conduct; and
the second switch (130) is closed such that one or more signals which are provided to the second switch control terminals are configured to cause the first of the plurality of first NMOS transistors in the chain and the final first NMOS transistor in the chain to conduct, and one or more signals which are provided to the second switch blanking control terminals are configured to cause each other first NMOS transistor of the plurality of first NMOS transistors and the plurality of parallel NMOS transistors to conduct;
when the apparatus (100) is in the fast-settle mode:
one or more signals which are provided to the first switch blanking control terminals and the second switch blanking control terminals are configured to cause one or more of the first PMOS transistors apart from the first and final first PMOS transistors in the chain, one or more of the first NMOS transistors apart from the first and final first NMOS transistors in the chain, the second PMOS transistors and the second NMOS transistors to not conduct, and one or more signals which are provided to the first switch control terminals and the second switch control terminals are configured to cause the first and final first PMOS transistors in the chain and the first and final first NMOS transistors in the chain to conduct, while the apparatus (100) is providing signalling to the antenna, and
one or more signals which are provided to the first switch blanking control terminals and the second switch blanking control terminals are configured to cause one or more of the first PMOS transistors apart from the first and final first PMOS transistors in the chain, one or more of the first NMOS transistors apart from the first and final first NMOS transistors in the chain, the second PMOS transistors and the second NMOS transistors to conduct, and one or more signals which are provided to the first switch control terminals and the second switch control terminals are configured to cause the first and last first PMOS transistors in the chain and the first and final first NMOS transistors in the chain to conduct, while the apparatus (100) is receiving signalling from the antenna.

13. The apparatus (100) of claim 2 or claim 3, wherein the receiver amplifier arrangement further comprises:
a first plurality of capacitors configured to, at least in part, cancel noise within the receiver amplifier arrangement;
a second plurality of capacitors configured to configured to, at least in part, cancel noise within the receiver amplifier arrangement;
one or more blanking supply voltage terminals configured to provide one or more blanking supply voltages; wherein
during the fast-settle mode, while the apparatus (100) is receiving signalling from the antenna, the receiver amplifier arrangement is configured to provide the one or more blanking supply voltages to the first plurality of capacitors and the second plurality of capacitors.

14. The apparatus (100) of claim 2 or claim 3, wherein:
a first PMOS transistor of the pair of PMOS transistors comprises:
a source terminal coupled to the third differential input-output pin (107A);
a drain terminal coupled to a first output terminal;
a gate terminal coupled to a first terminal of a first-part first capacitor, wherein a second terminal of the first-part first capacitor is coupled to the fourth differential input-output pin (107B);
a second PMOS transistor of the pair of PMOS transistors comprises:
a source terminal coupled to the fourth differential input-output pin (107B);
a drain terminal coupled to a second output terminal;
a gate terminal coupled to a first terminal of a first-part second capacitor, wherein a second terminal of the first-part second capacitor is coupled to the third differential input-output pin (107A);
the first part of the low noise amplifier circuit further comprises:
a first-part blanking supply voltage terminal configured to provide a first-part blanking supply voltage; and
a first-part blanking transistor with a drain terminal connected to the first-part blanking supply voltage terminal, a source terminal connected to the first terminal of the first-part first capacitor and the first terminal of the first-part second capacitor and a gate terminal connected to a first-part blanking control terminal;
a first NMOS transistor of the pair of NMOS transistors comprises:
a source terminal coupled to the fifth differential input-output pin (109A);
a drain terminal coupled to the first output terminal;
a gate terminal coupled to a first terminal of a second-part first capacitor, wherein a second terminal of the second-part first capacitor is coupled to the sixth differential input-output pin (109B);
a second NMOS transistor of the pair of NMOS transistors comprises:
a source terminal coupled to the sixth differential input-output pin (109B);
a drain terminal coupled to the second output terminal;
a gate terminal coupled to a first terminal of a second-part second capacitor, wherein a second terminal of the second-part first capacitor is coupled to the fifth differential input-output pin (109A);
the second part of the low noise amplifier circuit further comprises:
a second-part blanking supply voltage terminal configured to provide a second-part blanking supply voltage; and
a second-part blanking transistor with a drain terminal connected to the fourth supply voltage terminal, a source terminal connected to the first terminal of the second-part first capacitor and the first terminal of the second-part second capacitor and a gate terminal connected to a second-part blanking control terminal.

15. The apparatus (100) of claim 14, wherein:
when the apparatus (100) is in the transmit mode, one or more signals which are provided to the first-part blanking control terminal and the second-part blanking control terminal are configured to cause the first-part blanking transistor and the second-part blanking transistor to not conduct;
when the apparatus (100) is in the receive mode, one or more signals which are provided to the first-part blanking control terminal and the second-part blanking control terminal are configured to cause the first-part blanking transistor and the second-part blanking transistor to conduct; and
when the apparatus (100) is in the fast-settle mode:
one or more signals which are provided to the first-part blanking control terminal and the second-part blanking control terminal are configured to cause the first-part blanking transistor and the second-part blanking transistor to not conduct while the apparatus (100) is providing signalling to the antenna, such that charge over the first-part first capacitor and the first-part second capacitor and the charge over the second-part first capacitor and the second-part second capacitor remains unchanged, and
one or more signals which are provided to the first-part blanking control terminal and the second-part blanking control terminal are configured to cause the first-part blanking transistor and the second-part blanking transistor to conduct while the receiver amplifier arrangement is receiving signalling from the antenna pin (101).
